(19) **Europäisches Patentamt**

**European Patent Office**

**Office européen des brevets**

(11) Veröffentlichungsnummer: **0 180 003**
**A2**

(12) ## EUROPÄISCHE PATENTANMELDUNG

(21) Anmeldenummer: 85110971.0

(22) Anmeldetag: 30.08.85

(51) Int. Cl.⁴: **H01L 29/08** , H01L 29/72

(30) Priorität: 28.09.84 DE 3435828

(43) Veröffentlichungstag der Anmeldung:
07.05.86 Patentblatt 86/19

(84) Benannte Vertragsstaaten:
DE FR GB IT SE

(71) Anmelder: **Siemens Aktiengesellschaft**
**Berlin und München Wittelsbacherplatz 2**
**D-8000 München 2(DE)**

(72) Erfinder: **Stoisiek, Michael, Dr. Dipl.-Phys.**
**Ostpreussenstrasse 6**
**D-8012 Ottobrunn(DE)**

(54) **Bipolarer Leistungstransistor.**

(57) Bipolarer vertikaler Leistungstransistor mit einem parallel zur Basis-Emitterstrecke liegenden Schaltungsteil zur Beeinflussung des Abschaltverhaltens, bei dem ein mit einem Kollektorkontakt (7) versehener Halbleiterkörper (1) eines ersten Leitfähigkeitstyps eine die Basis darstellende, mit einem Basiskontakt (4) versehene Zone (3) des zweiten Leitfähigkeitstyps enthält und bei dem in die Zone (3) wenigstens ein Emittergebiet (5) des ersten Leitfähigkeitstyps eingefügt ist, das mit einem Emitterkontakt (6) versehen ist. Angestrebt wird eine schnelle Abschaltung des Leistungstransistors bei leistungsloser Ansteuerung. Erreicht wird das durch einen in den Halbleiterkörper monolithisch integrierten Feldeffekttransistor (T1), bestehend aus einem in die Zone (3) eingefügten Sourcegebiet des ersten Leitfähigkeitstyps, aus einem durch den Rand des Emittergebiets (5) gebildeten Draingebiet und aus dem Teil der Zone (3), der zwischen dem Emittergebiet (5) und dem Sourcegebiet (8) liegt und durch eine Gateelektrode (10) überdeckt wird. Die Gateelektrode (10) ist mit einem Steuereingang (11) für eine die Abschaltung bewirkende Steuerspannung ($U_a$) verbunden. Der Anwendungsbereich umfaßt bipolare Leistungshalbleiter.

**FIG 1**

EP 0 180 003 A2

Bipolarer Leistungstransistor mit einem parallel zur Basis-Emitterstrecke liegenden Schaltungsteil zur Beeinflussung des Abschaltverhaltens

Die Erfindung bezieht sich auf einen bipolaren Leistungstransistor mit einem parallel zur Basis-Emitterstrecke liegenden Schaltungsteil zur Beeinflussung des Abschaltverhaltens nach dem Oberbegriff des Patentanspruchs 1.

Ein Leistungstransistor dieser Art ist beispielsweise aus dem Handbuch für Schalttransistoren der Fa. Thomson-CSF, 1979, S. 28-29, bekannt. Nachteilig ist hierbei, daß der genannte Schaltungsteil so ausgebildet ist, daß dem Leistungstransistor zum Zwecke des Ausschaltens entweder ein negativer Strom über den Basiskontakt zugeführt oder ein niederohmiger Emitter-Basis-Nebenschluß zugeschaltet wird, was einen relativ großen Schaltungsaufwand erfordert.

Der Erfindung liegt die Aufgabe zugrunde, einen bipolaren Leistungstransistor der eingangs erwähnten Art anzugeben, der trotz eines wesentlich einfacheren Aufbaus als der oben beschriebene schnell ausgeschaltet werden kann. Das wird erfindungsgemäß durch eine Ausbildung gemäß dem kennzeichnenden Teil des Patentanspruchs 1 erreicht.

Der mit der Erfindung erzielbare Vorteil besteht insbesondere darin, daß das schnelle Ausschalten des Leistungstransistors ohne großen schaltungstechnischen Aufwand durch die bloße Spannungsansteuerung eines mono lithisch integrierten Feldeffekttransistors erreicht wird, wobei die Leitendschaltung des Feldeffekttransistors den Übergang vom stromführenden in den gesperrten Zustand bewirkt.

Die Ansprüche 2 bis 6 sind auf bevorzugte Ausgestaltungen und Weiterbildungen der Erfindung gerichtet.

Die Erfindung wird nachfolgend anhand der Zeichnung näher erläutert. Dabei zeigt:

Fig. 1 ein erstes Ausführungsbeispiel der Erfindung,

Fig. 2 ein zweites Ausführungsbeispiel mit einer selbstgesteuerten Ausschaltung des Leistungstransistors,

Figuren 3 und 4 Diagramme zur Erläuterung von Fig. 2;

Fig. 5 eine Draufsicht auf einen erfindungsgemäßen Leistungstransistor und

Fig. 6 eine Draufsicht auf einen alternativ zur Fig. 5 ausgebildeten Leistungstransistor nach der Erfindung.

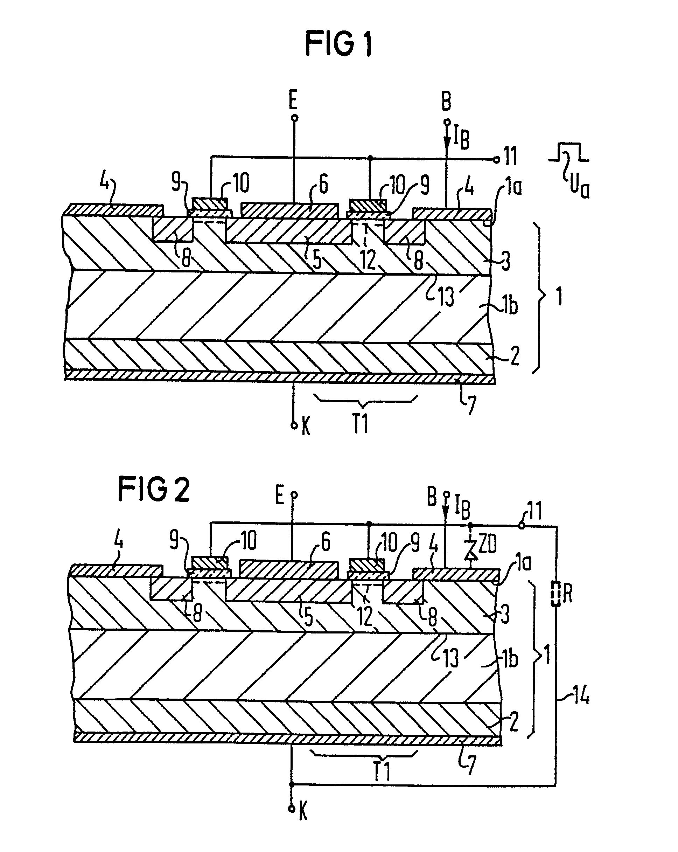

In Fig. 1 ist ein Teil eines scheibenförmigen Körpers 1 aus dotiertem Halbleitermaterial, z.B. Silizium, dargestellt, der eine erste Teilschicht 1b mit einer Dotierungskonzentration von z.B. $10^{14} cm^{cm-3}$ und eine unter dieser liegende, zweite Teilschicht 2 mit einer Dotierungskonzentration von z.B. $10^{17} cm^{-3}$ aufweist. Beide Teilschichten 1b und 2 sind n-leitend und stellen den Kollektor eines vertikalen bipolaren Leistungstransistors dar. Die Basis dieses Transistors besteht aus einer in 1 eingefügten p-leitenden Zone 3 mit einer Dotierungskonzentration von z.B. $10^{16} cm^{-3}$, die sich bis zur Grenzfläche 1a erstreckt und in dieser mit einem Basiskontakt 4 versehen ist, der mit einem Basisanschluß B in Verbindung steht. In die Zone 3 ist ein n-leitendes Emittergebiet 5 eingefügt, das über einen in der Grenzfläche 1a liegenden Emitterkontakt 6 mit einem Emitteranschluß E verbunden ist. Die zweite Teilschicht 2 ist mit einem Kollektorkontakt 7 versehen, der an einen Kollektoranschluß K gelegt ist.

Zwischen dem Emitteranschluß E und dem Basisanschluß B liegt ein in den Halbleiterkörper monolithisch integrierter Feldeffekttransistor T1 des Anreicherungstyps, bestehend aus einem $n^+$-dotierten Sourcegebiet 8, das in der Grenzfläche 1a von 4 kontaktiert wird, aus einem durch die Randzone des Emittergebiets 5 gebildeten Draingebiet und aus dem zwischen 5 und 8 liegenden Teil der Zone 3, der von einer durch eine Gateisolationsschicht 9 von der Grenzfläche 1a getrennten Gateelektrode 10 überdeckt wird. Die Gateelektrode 10 ist mit einem Steuereingang 11 verbunden. T1 stellt eine über 11 steuerbare Emitter-Basis-Kuzschlußstruktur dar. Wird eine positive Steuerspannung $U_a$ an den Eingang 11 gelegt, so bildet sich in dem an 1a angrenzenden Teil der Zone 3 unterhalb der Gateelektrode 10 ein Inversionskanal 12 aus, der die Teile 5 und 8 und damit die Anschlüsse E und B niederohmig miteinander verbindet bzw. kurzschließt. Bei spannungslosem Steuereingang 11 ist der Inversionskanal 12 nicht vorhanden, so daß der Kurzschluß unwirksam ist.

Im stromführenden Zustand des Leistungstransistors fließt in Abhängigkeit von einem über B in Pfeilrichtung eingespeisten Basisstrom $I_B$ ein Laststrom zwischen K und E. Dabei liegt in einem äußeren Laststromkreis eine Kollektorspannungsquelle, die K positiv gegen E vorspannt.

Wird nun eine positive Steuerspannung $+U_a$ an den Steuereingang 11 gelegt, so wird der Laststrom über den durch die Teile 4, 8, 12, 5 und 6 gebildeten, extrem niederohmigen Pfad dem Emitteranschluß E zugeführt, was auch auch bei weiterer Einspeisung des Basisstroms $I_B$ zu einer schnellen Abschaltung des Leistungstransistors führt.

Eine bevorzugte Weiterbildung der Erfindung ist in Fig. 2 dargestellt. Sie unterscheidet sich von Fig. 1 lediglich dadurch, daß der Steuereingang 11 mit dem Kollektoranschluß K über eine Leitung 14 verbunden ist. Die übrigen Schaltungsteile entsprechen der Fig. 1 und sind mit denselben Bezugszeichen wie dort versehen.

Bleibt im Betrieb des Leistungstransistors nach Fig. 2 die an K liegende Kollektorspannung unter der Einsatzspannung von T1, so weist der Transistor die übliche Abhängigkeit des Kollektorstroms von Kollektorspannung und Basisstrom $I_B$ auf. Sobald jedoch die Kollektorspannung die Einsatzspannung von T1 überschreitet, bildet sich der Inversionskanal 12 aus, die Anschlüsse E und B werden niederohmig verbunden und der Transistor wird ausgeschaltet. Ein Betrieb des Transistors mit einer Kollektorspannung, die größer ist als die Einsatzspannung von T1, wird auf diese Weise unmöglich gemacht. Die Einsatzspannung von T1 kann durch eine entsprechende Dotierungskonzentration des zwischen 5 und 8 liegenden Teils der Zone 3 und durch die Dicke der Gateisolationsschicht 9 auf einen gewünschten Wert eingestellt werden. Hierbei gilt, daß die Einsatzspannung mit ansteigender Dotierungskonzentration und Dicke der Gateisolationsschicht ebenfalls ansteigt.

Mit Vorteil werden in Fig. 2 eine Zenerdiode ZD zwischen den Steuereingang 11 und den Basisanschluß B bzw. den Basiskontakt 4 geschaltet und ein Strombegrenzungswiderstand R in die Leitung 14 eingefügt. Mittels R und ZD wird eine Spannungsteilung der an K anliegenden Sperrspannung bewirkt und dabei verhindert, daß die an der Gateisolationsschicht 9 anliegende Teilspannung die Steuerspannung von ZD übersteigt, so daß die Schicht 9 nicht über die Durchbruchfeldstärke hinaus belastet werden kann.

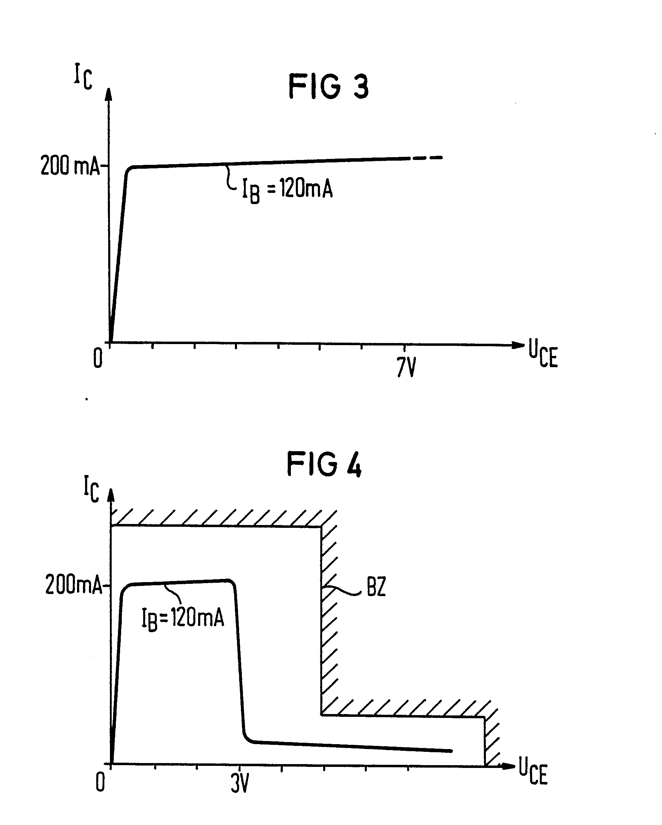

Fig. 3 zeigt die Abhängigkeit des Kollektorstroms $I_C$ von der Kollektor-Emitter-Spannung $U_{CE}$ bei einem Leistungstransistor nach Fig. 1, dessen Steuereingang 11 von Spannungen freigeschaltet ist. Wie ersichtlich, steigt $I_C$ bei einem Basisstrom $I_B$ von etwa 120 mA für Werte von $U_{CE}$, die oberhalb von 1 Volt liegen, auf etwa 200 mA an. Für $U_{CE}$ = 7 Volt ergibt sich ein Kollektorstrom $I_C$ von etwa 220 mA. Wird jedoch der Steuereingang 11 mit K verbunden, so ergibt sich unter den gleichen Bedingungen der in Fig. 4 dargestellte Verlauf der $I_C/U_{CE}$-Kurve. Trotz eines konstant eingespeisten Basisstroms $I_B$ von 120 mA fällt der Kollektorstrom $I_C$ beim Erreichen der Einsatzspannung, die im vorliegenden Fall etwa 3 Volt beträgt, durch $U_{CE}$ infolge des Ausschaltens des Transistors steil ab. Durch eine entsprechende Wahl der Einsatzspannung gelingt es also, den Betrieb des Transistors auf den z.B. durch BZ begrenzten Bereich des $I_C/U_{CE}$-Diagramms zu beschränken und damit eine thermische Zerstörung des Leistungstransistors sicher zu vermeiden.

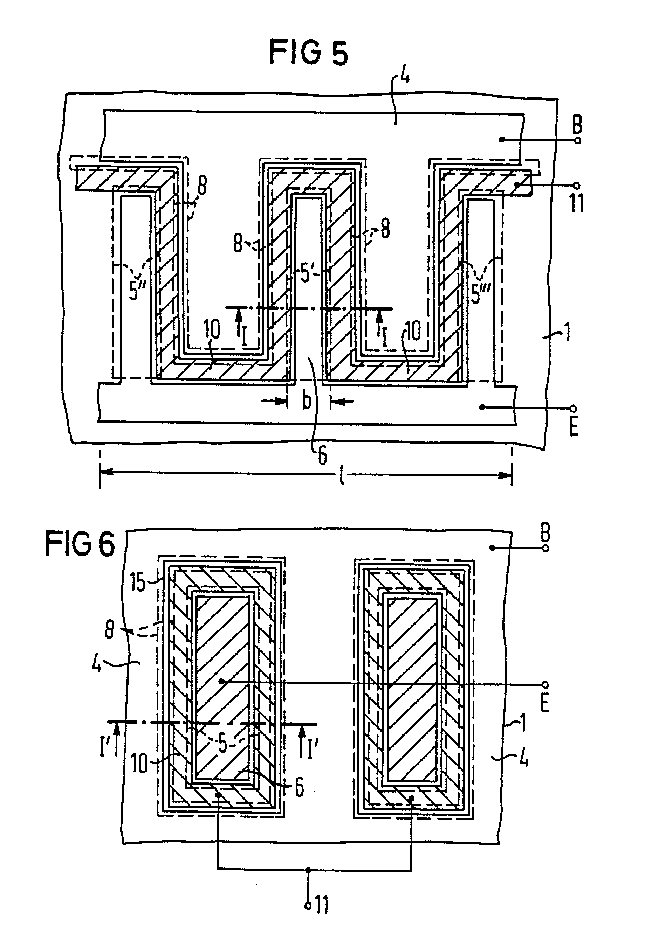

Fig. 5 zeigt eine Draufsicht auf eine bevorzugte Ausgestaltung des Leistungstransistors nach Fig. 1. Das Emittergebiet besteht hierbei aus mehreren in vertikaler Richtung verlaufenden, streifenförmigen Teilgebieten 5', 5" und 5'''. Der Emitterkontakt 6 hat eine kammförmige laterale Begrenzung mit drei nach oben zeigenden fingerartigen Ansätzen, die diese Teilgebiete kontaktieren, und mit einem unteren horizontal verlaufenden Steg. Fig. 1 ist dabei als Schnittdarstellung entlang der Linie I - I von Fig. 5 aufzufassen. Das Sourcegebiet 8 verläuft in Fig. 5 mäanderförmig entlang der oberen Begrenzung von 6. Dementsprechend weist auch die Gateelektrode 10 einen solchen mäanderförmigen Verlauf auf. Der Basiskontakt 4 ist seinerseits kammartig ausgeformt und ragt mit zwei nach unten zeigenden fingerartigen Ansätzen in die Zwischenräume der nach oben gerichteten Ansätze des Emitterkontakts 6. Diese Ausgestaltung kann als eine Verfingerung der Emitter- und Basiskontakte 6, 4 bezeichnet werden.

Figur 6 zeigt eine Draufsicht auf eine andere bevorzugte Ausgestaltung des Leistungstransistors nach Figur 1. Das Emittergebiet 5 hat in diesem Fall eine rechteckförmige bzw. streifenförmige laterale Begrenzung. Dementsprechend weisen auch das Sourcegebiet 8, die Gateelektrode 10 und der Emitterkontakt 6 rechteckförmige Begrenzungen auf. Der Basiskontakt 4 ist mit einer rechteckförmigen Ausnehmung 15 versehen, so daß er den äußeren Rand des Sourcegebiets 8 geringfügig überlappt. Fig. 1 ist hierbei als Schnittdarstellung entlang der Linie I' - I' von Fig. 6 aufzufassen. Eine zweite, gleichartig ausgebildete, inselförmige Emitterstruktur ist nach Fig. 6 neben der vorstehend beschriebenen angeordnet. Die Anschlüsse E und 11 sind mit den einander entsprechenden Teilen 6 und 10 beider Strukturen beschaltet. Der Basiskontakt 4 umgibt beide Emitterstrukturen und weist für jede von ihnen eine Ausnehmung auf.

Mit besonderem Vorteil sind eine Vielzahl von kammartigen Emitterkonstakten 6 und Emitterteilgebieten 5' bis 5''', die gemäß Fig. 5 ausgebildet und mit entsprechenden Basisstrukturen verfingert sind, bzw. eine Vielzahl von inselförmigen Emitterstrukturen nach Fig. 6 über die Grenzfläche 1a des Halbleiterkörpers 1 gleichmäßig verteilt. Die Teile 4, 6 und 10 dieser Strukturen sind jeweils an gemeinsame Anschlüsse E, B und 11 des Leistungstransistors geschaltet. Dabei kann ein Emitterteilgebiet 5' nach Fig. 5 z.B. eine Breite b von 50 μm und eine Länge von etwa 1 mm aufweisen. Die Länge einer kammartigen Emitterkontaktstruktur 6, die in Fig. 5 mit l angedeutet ist, kann z.B. 5 mm betragen. Die Eindringtiefe eines Emittergebiets 5 oder 5' in die Zone 3 wird zweckmäßigerweise mit 0,3 bis 2 μm bemessen. Die Dicke der Zone 3 kann etwa 3 bis 5 μm betragen, während die Dicke der Teilschicht 1b z. B. zu 10 bis 50 μm gewählt ist.

Die Teilschichten 1b und 2 können in Abweichung von Fig. 1 auch durch eine einheitlich dotierte, n-leitende Schicht ersetzt sein.

Neben den bisher beschriebenen Ausführungsformen der Erfindung sind auch solche von Interesse, bei denen die einzelnen Halbleiterteile durch solche des entgegengesetzten Leitfähigkeitstyps und die zum Betrieb erforderlichen Ströme und Spannungen durch solche entgegengesetzter Polarität ersetzt sind.

## Ansprüche

1. Bipolarer Leistungstransistor mit einem parallel zur Basis-Emitterstrecke liegenden Schaltungsteil zur Beeinflussung des Abschaltverhaltens, bei dem ein mit einem Kollektorkontakt versehener Halbleiterkörper eines ersten Leitfähigkeitstyps eine die Basis darstellende und in einer Grenzfläche mit einem Basiskontakt versehene Zone des zweiten Leitfähigkeitstyps aufweist und bei dem in die Zone wenigstens ein Emittergebiet des ersten Leitfähigkeitstyps eingefügt ist, das in der Grenzfläche mit einem Emitterkontakt versehen ist, **dadurch gekennzeichnet,** daß eine Emitter-Basis-Kurzschlußstruktur vorgesehen ist, die aus einem in den Halbleiterkörper monolithisch integrierten Feldeffekttransistor (T1) besteht, daß dieser ein neben dem Emittergebiet (5) in die Zone (3) eingefügtes Source-Gebiet (8) des ersten Leitfähigkeitstyps aufweist, das mit dem Basiskontakt (4) leitend verbunden ist, daß die Randzone des Emittergebiets (5) das Draingebiet des Feldeffekttransistors (T1) bildet und daß eine den zwischen dem Emittergebiet (5) und dem Sourcegebiet (8) liegenden Teil der Zone (3) überdeckende und von dem Halbleiterkörper (1) durch eine dünne elektrisch isolierende Schicht (9) getrennte Gateelektrode (10) vorgesehen ist, die mit einem Steuereingang (11) für eine die Abschaltung bewirkende Steuerspannung versehen ist.

2. Bipolarer Leistungstransistor nach Anspruch 1, **dadurch gekennzeichnet,** daß der Steuereingang (11) mit einem Anschluß (K) des Kollektorkontaktes (7) über eine Leitung (14) verbunden ist.

3. Bipolarer Leistungstransistor nach Anspruch 2, **dadurch gekennzeichnet,** daß eine Zehnerdiode (ZD) zwischen den Steuereingang (11) und den Basiskontakt (4) geschaltet ist und daß in die Leitung (14) ein Strombegrenzungswiderstand (R) eingefügt ist.

4. Bipolarer Leistungstransistor nach einem der Ansprüche 1 bis 3, **dadurch gekennzeichnet,** daß der Emitterkontakt (6) kammartige laterale Begrenzungen mit mehreren fingerartigen Ansätzen und jeweils einem diese miteinander verbindenden Steg aufweist, daß mehrere Emitterteilgebiete (5', 5", 5''') jeweils unterhalb der fingerartigen Ansätze liegen und daß der Basiskontakt (4) ebenfalls kammartig geformt ist, wobei er mit seinen Ansätzen in die Zwischenräume der Ansätze des Emitterkontakts (6) ragt.

5. Bipolarer Leistungstransistor nach einem der Ansprüche 1 bis 3, **dadurch gekennzeichnet,** daß das Emittergebiet (5) sowie der Emitterkontakt (6) im wesentlichen rechteckförmige laterale Begrenzungen aufweisen und daß der Basiskontakt (4) eine im wesentlichen rechteckförmige Ausnehmung (15) besitzt, so daß sein die Ausnehmung (15) begrenzender Rand das Sourcegebiet (8) des Feldeffekttransistors geringfügig seitlich überlappt.

6. Bipolarer Leistungstransistor nach einem der vohergehenden Ansprüche, **dadurch gekennzeichnet** daß eine Vielzahl von Emittergebieten nebeneinander auf der Grenzfläche (1a) des Halbleiterkörpers (1) angeordnet sind.

# FIG 1

# FIG 2

FIG 3

FIG 4

## FIG 5

## FIG 6